# EUROPEAN PATENT APPLICATION

(11) **EP 4 804 762 A1**
(43) Date of publication of application: **09.09.2026**
(21) Application number: 25175124.4
(22) Date of filing: 08.05.2025
(51) Int. Cl.: H10D 84/90, H10D 89/10, G06F 30/392, G06F 30/394, H01L 23/528

(54) **BOUNDARY CELL ARCHITECTURE**

(30) Priority: 06.03.2025 IN 202541020260
(71) Applicant: NXP B.V., 5656 AG Eindhoven (NL)
(72) Inventor: Dharmavaram, Ramanath, 5656AG Eindhoven (NL); Gourimath, Suhas Chandrakant Swami, 5656AG Eindhoven (NL); Krishnakumar, Reshma, 5656AG Eindhoven (NL); Bansal, Balram, 5656AG Eindhoven (NL)
(74) Representative: Schwarzweller, Thomas

(57) **Abstract**

There is provided boundary cells arranged to form a boundary between a first power domain and a second power domain. Each power domain has an associated power rail. The boundary cells physically and electrically isolate functional cells of the first power domain from functional cells of the second power domain. Each boundary cell comprises a first well tap having a first conductivity type provided within a first region of a substrate, wherein the first well tap is electrically connected to a ground rail, and a second well tap having a second conductivity type provided within a second region of the substrate, wherein the second well tap is electrically connected to the power rail of the first power domain. The power rails of each power domain extend partially across the boundary cell, the first power rail being physically and electrically isolated from the second power rail.

## Description

### TECHNICAL FIELD

The present disclosure relates to the provision of improved boundary cells between two power domains in an integrated circuit, wherein the improved boundary cells satisfy both end cap and well tap cell requirements of the two power domains.

### BACKGROUND

In integrated circuit design, it is common to have multiple power domains, each power domain being configured to operate at a different voltage. In particular, low power applications are often designed by having multiple power domains to meet power, performance and area (PPA) goals. Typically, there is a requirement for each power domain to be separated by boundary cells, an empty isolation region, and well tap cells on each side of the boundary. This is usually done to avoid any design rule violations and to prevent signal mixing between different power domains. As such, this is not a space efficient use of area on the substrate.

### SUMMARY

Aspects of the present disclosure are set out in the accompanying independent and dependent claims. Combinations of features from the dependent claims may be combined with features of the independent claims as appropriate and not merely as explicitly set out in the claims.

According to a first aspect of the present disclosure, there is provided an integrated circuit, comprising: a substrate, comprising a first region having a first conductivity type and a second region having a second conductivity type opposite to the first conductivity type, a first power domain, comprising a first plurality of functional cells, a second power domain, comprising a second plurality of functional cell, and a plurality of boundary cells arranged to form a boundary between the first power domain and the second power domain. The plurality of boundary cells physically and electrically isolate the first plurality of functional cells from the second plurality of functional cells.

For each row of cells, the functional cells of the first power domain are electrically connected to a first power rail and the functional cells of the second power domain are electrically connected to a second power rail. Each boundary cell comprises a first well tap having the first conductivity type provided within the first region of the substrate, wherein the first well tap is electrically connected to a ground rail, and a second well tap having the second conductivity type provided within the second region of the substrate, wherein the second well tap is electrically connected to the first power rail. The first and second power rails each extend partially across the boundary cell, the first power rail being physically and electrically isolated from the second power rail.

Optionally, an end of the first power rail and an end of the second power rail each extend partially across the boundary cell, the ends of the power rails being spaced apart from each other by a gap. The gap between the ends of the two power rails being a sufficient distance to ensure isolation between the two power rails.

Each boundary cell thus satisfies the requirements of a well tap cell and an endcap cell for both power domains.

The first power rail may be connected to a source node in the second region of the substrate of some or all of the functional cells of the first power domain.

The second power rail may be connected to a source node in the second region of the substrate of some or all of the functional cells of the second power domain.

It will be appreciated that each power domain is configured to operate at a respective power level or voltage. Thus, the first power domain will be configured to operate at a first power level or voltage and the second power domain will be configured to operate at a second power level or voltage different to the first power level or voltage.

Optionally, the first power domain and the second power domain may each comprise a respective ground rail. Each ground rail may be connected to source node of some or all of the functional cells of the respective power domain, in the first region of the substrate.

Optionally, the ground rail electrically connected to the first well tap is a common ground rail. Thus, the ground rail may extend continuously across the first power domain, the second power domain and the boundary (or the at least one boundary cell).

The ground rail may be connected to the first region of the substrate of the always on domain.

It will be appreciated that well taps or well-taps are known in the art, and any suitable well tap structure may be provided.

Optionally, the first well tap comprises a first oxide diffusion layer of the first conductivity type and a first metal interconnect structure electrically connecting the first oxide diffusion layer to the ground rail.

Optionally, the second well tap comprises a second oxide diffusion layer of the second conductivity type and a second metal interconnect structure electrically connecting the second oxide diffusion layer to the first power rail.

The second power rail may not be connected to the boundary cells by a well tap. Thus, each boundary cell does not comprise a well tap connected to the second power rail. In other words, the second power rail may not be connected internally to the boundary cell.

The plurality of boundary cells may be in direct contact with both the first power domain and the second power domain. Thus, no empty gaps or isolation cells may be provided between the boundary cells and the first and second power domains.

Optionally, the first conductivity type is a p-type conductivity and the second conductivity type is an n-type conductivity.

Optionally, the second conductivity type is a p-type conductivity and the first conductivity type is an n-type conductivity.

Optionally, for each row of cells, the second region of the substrate extends continuously across the first power domain, the boundary (or the at least one boundary cell) and the second power domain. Thus, the second region of the substrate may extend continuously across the boundary.

Optionally, for each row of cells, the first region of the substrate extends continuously across the first power domain, the boundary (or the at least one boundary cell) and the second power domain. Thus, the first region of the substrate may extend continuously across the boundary.

Optionally, the second region of the substrate may comprise a deep n-well region.

Optionally, the boundary is of single cell width, such that a single width line of boundary cells are provided between the first and second power domains.

Optionally, the plurality of boundary cells completely surround the first power domain.

It will be appreciated that the present disclosure is not limited to only two power domains. The boundary cells described can be used to separate any number of power domains provided on a substrate.

According to a first aspect of the present disclosure, there is provided a method of manufacturing an integrated circuit according to any embodiment of the first aspect of this disclosure.

The method comprises providing a first region of a substrate having a first conductivity type, providing a second region of the substrate having a second conductivity type opposite to the first conductivity type, providing a first power domain, comprising a first plurality of functional cells, providing a second power domain, comprising a second plurality of functional cells, and providing a plurality of boundary cells arranged to form a boundary between the first power domain and the second power domain, wherein the plurality of boundary cells physically and electrically isolate the first plurality of functional cells from the second plurality of functional cells.

The method further comprises providing, for each row of cells, a first power rail electrically connected to the functional cells of the first power domain and a second power rail electrically connected to the functional cells of the second power domain.

Providing each boundary cell comprises providing a first well tap having the first conductivity type within the first region of the substrate and electrically connecting the first well tap to a ground rail, and providing a second well tap having the second conductivity type within the second region of the substrate and electrically connecting the second well tap to the first power rail. The first and second power rails extend partially across the boundary cell and the first power rail is physically and electrically isolated from the second power rail.

It will be appreciated that the steps of: providing the first and second regions of the substrate; providing or constructing the first and second power domains; and constructing the power rails, are all known in the art and can be achieved via a variety of known fabrication techniques.

The method may further comprise, providing, for each row of cells, a first ground rail electrically connected to the functional cells of the first power domain and a second ground rail electrically connected to the functional cells of the second power domain. The ground rail of the boundary cells may comprise a third ground rail, or this third ground rail may be part of the first or second ground rails.

Optionally, the method further comprises, providing, for each row of cells, a ground rail extending continuously across the first power domain, the second power domain and the boundary (or the at least one boundary cell). The ground rail of the boundary cells may form part of a common ground rail.

Optionally, providing the first well tap comprises forming a first oxide diffusion layer of the first conductivity type within the first region of the substrate and providing a first metal interconnect structure electrically connecting the first oxide diffusion layer to the ground rail.

Optionally, providing the second well tap comprises forming a second oxide diffusion layer of the second conductivity type within the second region of the substrate and providing a second metal interconnect structure electrically connecting the second oxide diffusion layer to the first power rail.

Optionally, the method does not comprise providing a further well tap connecting the second power rail to the boundary cell. In other words, the second power rail may not be connected internally to the boundary cell.

Optionally, the first conductivity type is a p-type conductivity and the second conductivity type is an n-type conductivity.

Optionally, the second conductivity type is a p-type conductivity and the first conductivity type is an n-type conductivity.

Optionally, the plurality of boundary cells are in direct contact with both the first power domain and the second power domain.

Optionally, for each row of cells, the second region of the substrate extends continuously across the first power domain, the boundary (or the at least one boundary cell) and the second power domain.

Optionally, for each row of cells, the first region of the substrate extends continuously across the first power domain, the boundary cell (or the at least one boundary cell) and the second power domain.

Optionally, the second region of the substrate may comprise a deep n-well region.

Optionally, the boundary is of single cell width, such that a single width line of boundary cells are provided between the first and second power domains.

Optionally, the plurality of boundary cells completely surround the first power domain.

### BRIEF DESCRIPTION OF THE DRAWINGS

Embodiments of this disclosure will be described hereinafter, by way of example only, with reference to the accompanying drawings in which like reference signs relate to like elements and in which:
**Figure 1** is a schematic diagram illustrating a plan view of a prior art substrate layout for two power domains;
**Figure 2** is a schematic diagram illustrating a plan view of a prior art substrate layout for three power domains;
**Figure 3** is a schematic diagram illustrating a plan view of a substrate layout for three power domains according to an embodiment of this disclosure;
**Figure 4** illustrates a plan view of multiple rows of cells at the boundary between two power domains according to the prior art;
**Figure 5** illustrates a plan view of a single row of cells at the boundary between two power domains according to the prior art;
**Figure 6** illustrates a plan view of multiple rows of cells at the boundary between two power domains according to an embodiment of this disclosure;
**Figure 7** illustrates a plan view of a single row of cells at the boundary between two power domains according to an embodiment of this disclosure;
**Figure 8** illustrates a plan view of a single boundary cell according to an embodiment of this disclosure;
**Figure 9** is a partial view of the boundary cell in Figure 8, with some layers removed;
**Figure 10** is a cross-sectional representation of the boundary between two power domains according to an embodiment of this disclosure; and
**Figure 11** is a flowchart illustrating a method of manufacturing an integrated circuit according to an embodiment of this disclosure.

### DETAILED DESCRIPTION

Embodiments of this disclosure are described in the following with reference to the accompanying drawings.

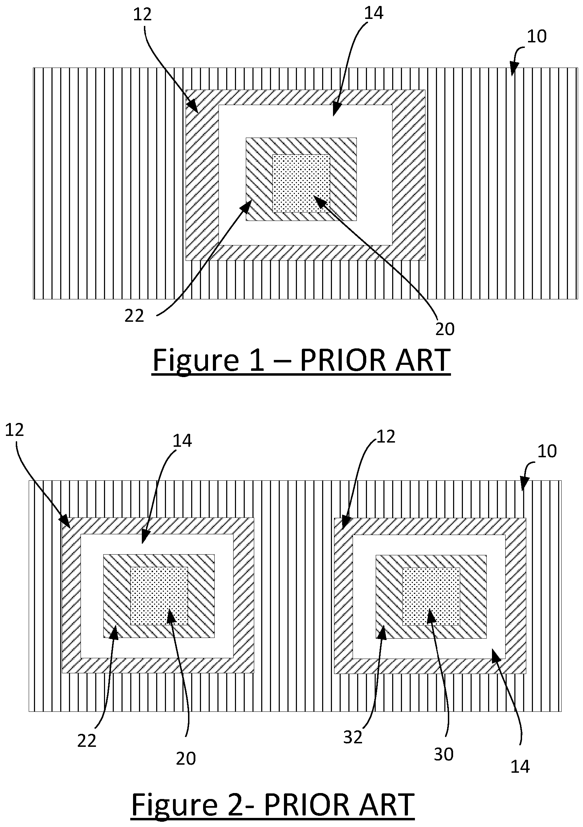

In integrated circuit design, particularly for low power applications, the integrated circuits are often designed to have several power domains to meet PPA goals. In the conventional approach, the power domains are separated on the substrate (or SoC) by creating power-domain specific islands. An example of this is shown in Figure 1, which illustrates a typical layout for two power domains on a substrate.

In Figure 1, a first power domain 10 comprises a first plurality of functional cells configured to operate at a first power level. A second power domain 20 comprises a second plurality of functional cells configured to operate at a second power level different to the first power level.

The functional cells of the second power domain 20 are surrounded by boundary cells 22. The functional cells of the first power domain 10 are surrounded by boundary cells 12. In between the two sets of boundary cells 12, 22 an isolation gap 14 is provided. The isolation gap 14 is an empty region. This is a typical design used in the prior art.

An example of a known layout for three power domains on a substrate is shown in Figure 2.

In Figure 2, a first power domain 10 comprises a first plurality of functional cells configured to operate at a first power level. A second power domain 20 comprises a second plurality of functional cells configured to operate at a second power level different to the first power level. A third power domain 30 comprises a third plurality of functional cells configured to operate at a third power level different to the first and second power levels.

The functional cells of the third power domain 30 are surrounded by boundary cells 32. The functional cells of the second power domain 20 are surrounded by boundary cells 22. The functional cells of the first power domain 10 are surrounded by boundary cells 12. Each set of boundary cells are separated by an isolation gap 14. Thus, a first isolation gap 14 is provided between boundary cells 12 and 22, and a second isolation gap 14 is provided between boundary cells 12 and 32. This is a typical design used in the prior art.

Accordingly, in the prior art, as shown in Figures 1 and 2, it is standard practice for each power domain to physically end with a boundary cell to prevent potential Design Rule Check violations and to ensure smooth closure of the p and n-well, and power rails before going to the other power domains. These terminating cells usually comprise a well tap cell, boundary cell and/or guard-ring cells. It is also conventional for the boundary between two power domains to include an empty isolation region, as shown. This approach of isolating two power domains results in under-utilization of physical floorplan area, which is undesirable particularly due to increasing wafer cost for sub-nm nodes.

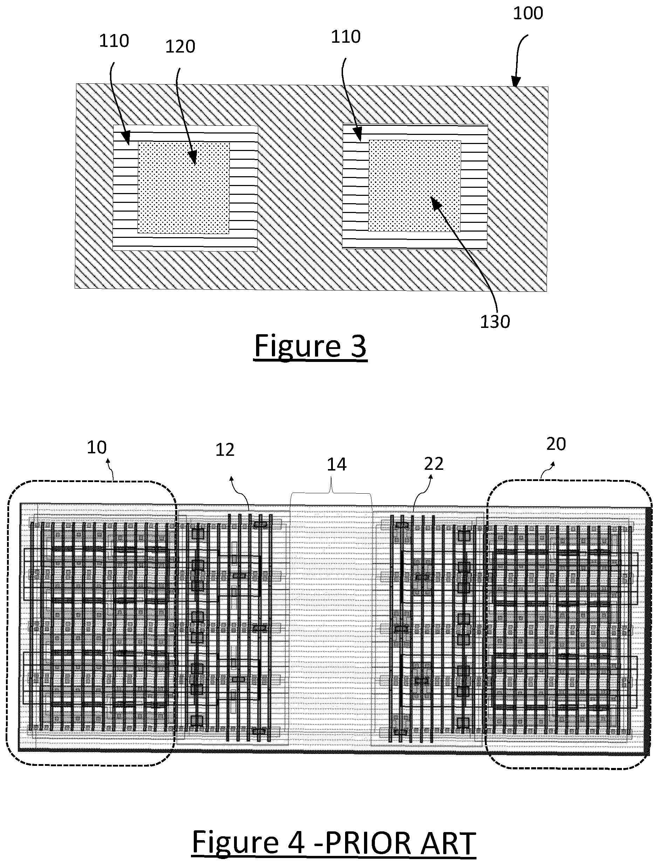

The present disclosure addresses these issues by replacing the two sets of boundary cells and the isolation gap with a novel type of boundary cell that still meets safety and operational requirements. This is illustrated in Figure 3 of the drawings.

As shown in Figure 3, a first power domain 100 comprises a first plurality of functional cells configured to operate at a first power level. A second power domain 120 comprises a second plurality of functional cells configured to operate at a second power level different to the first power level. A third power domain 130 comprises a third plurality of functional cells configured to operate at a third power level different to the first and second power levels. It will be appreciated that in other embodiments only two power domains may be provided, or more than three power domains may be provided.

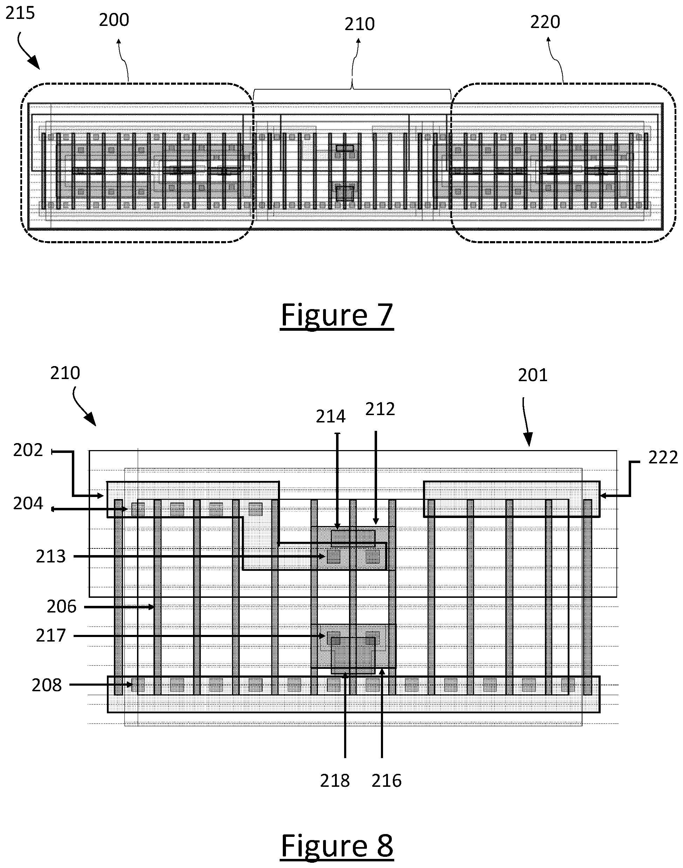

The functional cells of the second power domain 120 are physically and electrically isolated from the functional cells of the first power domain 100 by boundary cells 110. Similarly, the functional cells of the third power domain 130 are physically and electrically isolated from the functional cells of the first power domain 100 by boundary cells 110. Thus, only a single set of boundary cells 110 forms the boundary between two power domains, and no isolation gap is provided. This boundary is preferably a single width of boundary cells 110. The boundary cells 110 are configured to satisfy the requirements of a well tap and end cap cell (see Figure 8 described below).

It is clear that the layout shown in Figure 3 is a much more efficient use of space compared to the prior art layout in Figure 2, as the boundary cells 110 replace the two sets of prior art boundary cells and the isolation gap. Thus, in the present disclosure, the new boundary cells can bring the two power domains together, without creating any design rule violations or any inadvertent mix of signals from multiple power supplies, by ensuring power supply separation is taken care of inside the cell itself, without compromising on the reliability and PPA targets of the design. This allows for reduced die size, with better chip area utilization, reduced material costs, reduced routing lengths of the signals, which would eventually reduce the signal parasitics, thus offering performance improvement of the design.

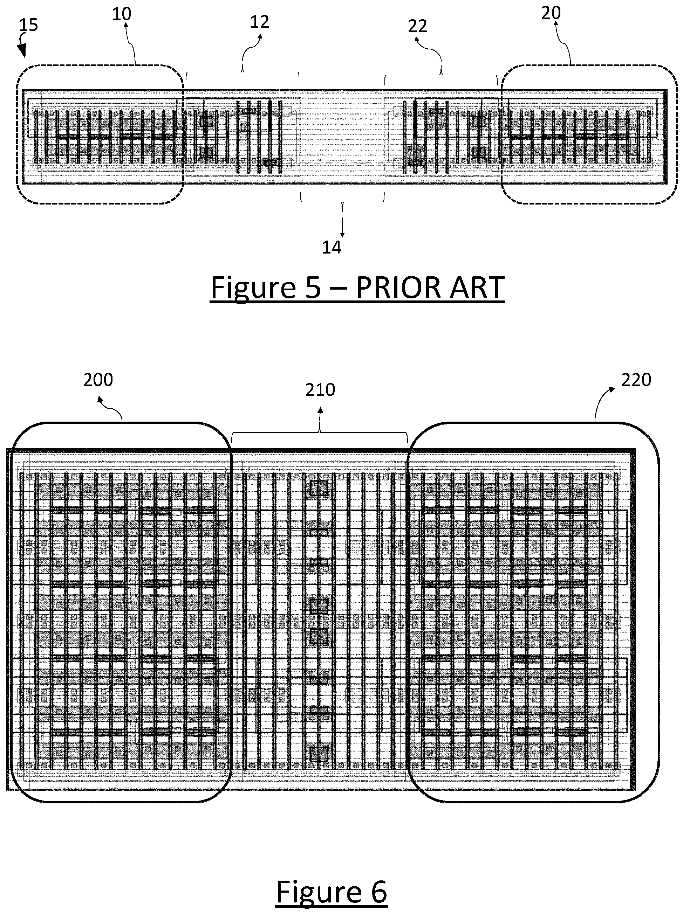

Figures 4 and 5 are more detailed diagrams illustrating a close up of a boundary between two power domains according to the prior art. Figure 4 shows a plan view of multiple rows of cells at the boundary between two power domains, and Figure 5 shows a single row of cells 15 at the boundary between two power domains. In both Figures 4 and 5, the integrated circuit comprises a first power domain 10 comprising a first plurality of functional cells and a second power domain 20 comprising a second plurality of functional cells. These functional cells are arranged in rows, as is standard in the art. At the boundary between the two power domains 10, 20, there is provided a first plurality of boundary cells 12 associated with the first power domain 10, an empty isolation gap 14, and a second plurality of boundary cells 22 associated with the second power domain 20. The first plurality of boundary cells 12 satisfy endcap and well tap requirements for the first power domain 10 and the second plurality of boundary cells 22 satisfy endcap and well tap requirements for the second power domain 20.

In comparison, Figures 6 and 7 are more detailed diagrams illustrating a close up of a boundary between two power domains according to an embodiment of this disclosure. Figure 6 shows a plan view of multiple rows of cells at the boundary between two power domains, and Figure 7 shows a single row of cells 215 at the boundary between two power domains.

In both Figures 6 and 7, the integrated circuit comprises a first power domain 200 comprising a first plurality of functional cells and a second power domain 220 comprising a second plurality of functional cells. These functional cells are arranged in rows, as is standard in the art. At the boundary between the two power domains 200, 220, there is provided a first plurality of boundary cells 210. The boundary cells 210 are in direct contact with both power domains 200, 220, such that no isolation gap is provided. As shown (in particular in Figure 7), the boundary is of single cell width, such that a single boundary cell 210 separates a functional cell of the first power domain 200 from a functional cell of the second power domain 220. The boundary cells 210 satisfy endcap and well tap requirements for both the first power domain 200 and the second power domain 220. Thus, the boundary cells 210 can be considered to integrate the two power domains, while maintaining isolation between the two power domains.

The boundary cells 210 of the present disclosure provide the following technical advantages:
- Different power and ground nets of the power domains, which are brought together, will be processed within the boundary cell, by adhering to the technology specific guidelines and electrical European Market Infrastructure Regulation (EMIR) requirements
- The boundary cells act as a bridge between to power domains smoothly integrating them with continuity of well regions
- The boundary cells adhere to standardized low-power IEEE 1801 Unified Power Format, so that its usage is seamless in the system on chip (SoC) design multiple power handling aspects and validation
- The boundary cells, which act like a bridge between two power domains, can be designed to adjust for different row heights of the power domains.

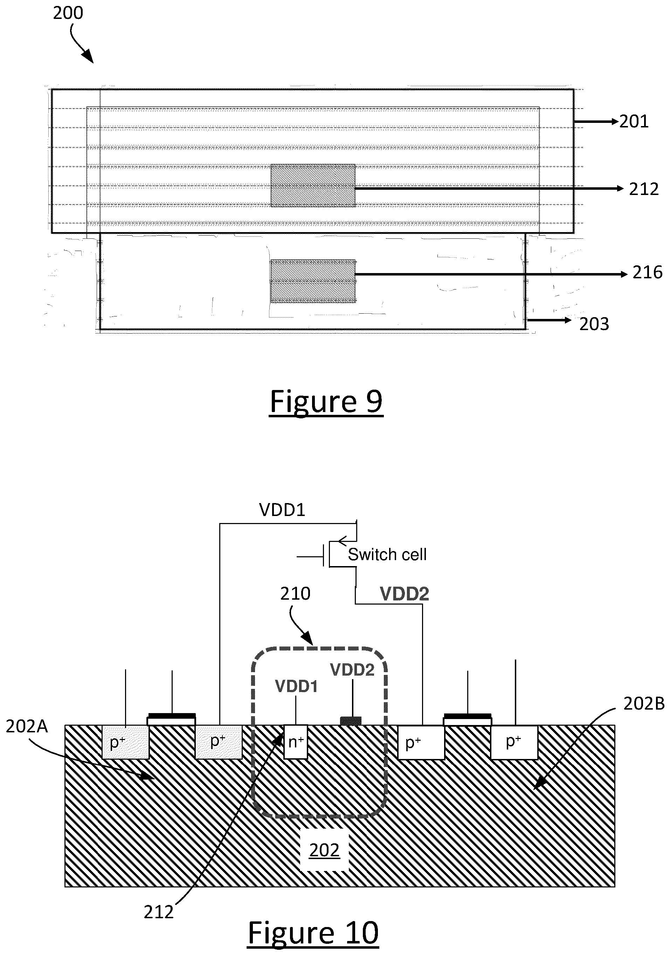

The layout or architecture of each boundary cell 210 that provides these technical advantages is shown in more detail in Figures 8 and 9. Figure 9 shows the boundary cell 210 with many layers removed, to see the underlying structure of the substrate regions. The substrate is typically of a p-type conductivity which is doped to have a region of n-type conductivity, usually referred to as an n-well. In the present disclosure, the n-well may be continuous across each row of cells (e.g. as shown in Figure 10). In Figures 8 and 9, the n-well (or region of n-type conductivity) corresponds to region 201 and the p-sub or region of p-type conductivity is region 203. It will be appreciated that in other embodiments, the substrate may have n-type conductivity and be doped to have a region of p-type conductivity (e.g. p-well). In some embodiments, a deep n-well structure may be provided.

As is standard in the art, each functional cell of the first and second power domains 200, 220 comprises a respective power rail (or VDD rail). However, rather than the power rails terminating in separate boundary cells 12, 22, as in Figures 4 and 5 of the prior art, in the present disclosure these two power rails both terminate in the same boundary cells 210. This is shown in Figure 8, as the first power rail (VDD1) 202 of the first power domain, and the second power rail (VDD2) 222 of the second power domain, extend partially across the boundary cell 210. Thus, an end of each power rail 202, 222, is located at the boundary cell 210. These two power rails 202, 222 are spaced apart, such that they are physically and electrically isolated.

In some embodiments of the present disclosure, as is shown in Figures 6 and 7, the first power domain 200, second power domain 220 and the boundary cells 210, may have a single or common ground rail (or VSS rail). This ground rail may extend continuously across the boundary between the power domains. In other embodiments, one or more of the power domains may have separate ground rails, or the ground rail of the boundary cells 210 may be separate to the ground rail of one or more of the power domains. In Figure 8, the ground rail of the boundary cell is rail 208.

It will be appreciated that the power rails 202, 222 and ground rail(s) 208, are formed by a metallization stack. A poly gate mask layer 206 is also provided at a constant pitch. The power rails 202, 222 and ground rail 208 are typically formed on the metal 1 mask layer of the stack. The first power rail 202 is electrically connected to the n-well region 201 of the substrate by a plurality of vias 204 formed by a VIA0 mask layer on the power rail. Similarly, the ground rail 208 is electrically connected to the p-sub region 203 of the substrate by a plurality of vias formed by a VIA0 mask layer on the ground rail. Although Figure 8 does not show any vias connected to the portion of the second power rail (VDD2) 222, in some embodiments a VIAO mask layer may also be provided on the second power rail 222.

Each boundary cell 210 comprises a first well tap (or p-well tap) that is configured to tie the ground rail 208 to the first region (p-sub region) 203 of the substrate, and a second well tap (or n-well tap) that is configured to tie the first power rail 202 to the second region (n-well region) 201 of the substrate. These well taps prevent latch-up problems (i.e. a parasitic structure forming which creates a low-impedance path between the power supply and ground). There is no well tap provided in the boundary cell 210 that is connected to the second power rail 222.

In Figure 8, the first well tap comprises a region 216 having p-type conductivity (i.e. the same as the first region of the substrate) provided in the first region 203 of the substrate. This may be an oxide diffusion layer. This region 216 is electrically connected to the ground rail (VSS) 208 by a metal interconnect structure (M0_PO interconnect) 218 and vias 217. Thus, the first well tap is formed of the combination of features 216, 217 and 218.

Similarly, the second well tap comprises a region 212 having n-type conductivity (i.e. the same as the second region of the substrate) provided in the second region 201 of the substrate. This may be an oxide diffusion layer. This region 212 is electrically connected to the first power rail (VDD1) 202 by a metal interconnect structure (M0_PO interconnect) 214 and vias 213. Thus, the second well tap is formed of the combination of features 212, 213 and 214. It will be appreciated that various well tap structures and configuration are known in the art, and any applicable structure and configuration may be used to form the well taps of this disclosure. Thus, the boundary cell 210 satisfies the requirements of a well tap (or well-tap) cell. Well taps prevent latch-up, in particular in CMOS designs, by ensuring proper biasing of the n-well and p-well regions, stabilizing voltages, and providing connectivity to the power and ground rails.

Figure 10 is a cross-sectional representation of the boundary in Figure 7. The n-well or second region 201 of the substrate is continuous across the boundary. The second or n-well tap 212 is shown within the second region 201 of the substrate which is electrically connected to VDD1 (the first power rail 202). For simplicity, the first region of the substrate and the first well tap are not shown in Figure 10. The second power rail VDD2 is not connected internally to the boundary cell 210, instead the metal rail overlays the boundary cell 210. Region 202A of the shared n-well is the PMOS of the first power domain 200 and region 202A of the shared n-well is the PMOS of the second power domain 220.

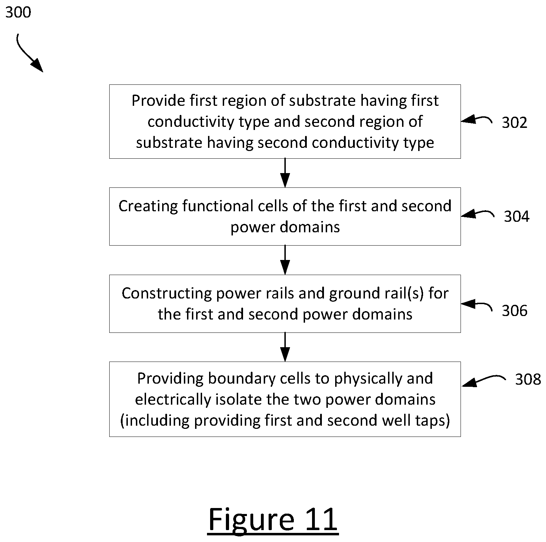

The present disclosure also provides a method 300 of manufacturing an integrated circuit according to any embodiment of this disclosure, as shown in Figure 11. At step 302, the method involves providing a first region of a substrate having a first conductivity type and a second region of the substrate having a second conductivity type opposite to the first type. In other words, step 302 comprises the creation of the p-sub and n-well. However, in some embodiments these conductivity types may be reversed. It will be appreciated that there are a variety of known techniques (e.g. deposition, doping, implantation, etc.) that can be used in step 302.

At step 304, the method proceeds to the semiconductor fabrication process to create other layers to build the functional cells of the two power domains. This creates the necessary functional cells in each power domain as desired. Again, this process is known in the art.

At step 306, the power rails and ground rail(s) of the power domains are constructed for the plurality of functional cells in the first and second power domains, as per the design considerations. However, in contrast to usual requirements, the two power rails extend at least partially across the boundary between the two power domains. Step 306 may include providing a single shared ground rail that extends across two power domains and the boundary cells.

At step 308, the method includes providing or constructing the new boundary cells according to the present disclosure (e.g. as shown in Figure 8) to physically and electrically isolate the first power domain from the second power domain. Thus, step 308 includes providing the first and second well taps, and electrically connecting the first well tap to the ground rail and electrically connecting the second well tap to the first power rail. The electrical connections may be provided by metal interconnect structures and optionally vias, as shown in Figure 8.

It will be appreciated that one or more steps of method 300 may occur concurrently, or the order of some of the steps may be reversed.

Accordingly, this disclosure presents a new type of boundary cell, for providing the desired isolation between power domains, which is placed at the boundary of the two power domains. The new boundary cell replaces the two sets of boundary and well-tap cells and the isolation gap used in the prior art. Thus, the new boundary cell does not consume as much space on the substrate, or require any wasted "empty" space. Electrically, the new boundary cell also facilitates appropriate supply connections of the involved power and ground nets with necessary isolation, for reliable operation complying to the design guidelines. This new boundary cell design is technology agnostic; thus, it brings the power domains together by adhering to the respective technology fabrication design guidelines. Since it sits in both power domains in an optimal manner, it is able to save significant design area.

The EDA timing view of the boundary cell is updated with the Electronic Industry Low power format, IEEE 1801 UPF standard format attributes, so that this IP will seamlessly fit in low-power flow implementation and validation, thus avoiding incorrect implementation of the IP in SoC design flow.

This new boundary cell can be implemented in any integrated circuit which has multiple power domains. The use of the new boundary cells has been found to save up to 1-4% of block area and around 1% of digital chip design area.

Although particular embodiments of this disclosure have been described, it will be appreciated that many modifications/additions and/or substitutions may be made within the scope of the claims.

## Claims

1. An integrated circuit comprising:
a substrate, comprising a first region having a first conductivity type and a second region having a second conductivity type opposite to the first conductivity type;
a first power domain, comprising a first plurality of functional cells;
a second power domain, comprising a second plurality of functional cells; and
a plurality of boundary cells arranged to form a boundary between the first power domain and the second power domain, wherein the plurality of boundary cells physically and electrically isolate the first plurality of functional cells from the second plurality of functional cells,
wherein, for each row of cells:
the functional cells of the first power domain are electrically connected to a first power rail;
the functional cells of the second power domain are electrically connected to a second power rail; and
wherein each boundary cell comprises:
a first well tap having the first conductivity type provided within the first region of the substrate, wherein the first well tap is electrically connected to a ground rail;
a second well tap having the second conductivity type provided within the second region of the substrate, wherein the second well tap is electrically connected to the first power rail; and
wherein the first and second power rails each extend partially across the
boundary cell, the first power rail being physically and electrically isolated from the second power rail.

2. The integrated circuit of claim 1, wherein, for each row of cells, the ground rail extends continuously across the first power domain, the second power domain and the boundary.

3. The integrated circuit of any preceding claim, wherein:
the first well tap comprises a first oxide diffusion layer of the first conductivity type and a first metal interconnect structure electrically connecting the first oxide diffusion layer to the ground rail; and
the second well tap comprises a second oxide diffusion layer of the second conductivity type and a second metal interconnect structure electrically connecting the second oxide diffusion layer to the first power rail.

4. The integrated circuit of any preceding claim, wherein the plurality of boundary cells are in direct contact with both the first power domain and the second power domain.

5. The integrated circuit of any preceding claim, wherein the first conductivity type is a p-type conductivity and the second conductivity type is an n-type conductivity.

6. The integrated circuit of any preceding claim, wherein, for each row of cells:
the second region of the substrate extends continuously across the first power domain, the boundary and the second power domain; and/or
the first region of the substrate extends continuously across the first power domain, the boundary and the second power domain.

7. The integrated circuit of any preceding claim, wherein, for each boundary cell, the second power rail is not connected to the boundary cell by a well tap.

8. The integrated circuit of any preceding claim, wherein the boundary is of single cell width, such that a single width line of boundary cells are provided between the first and second power domains.

9. The integrated circuit of any preceding claim, wherein the plurality of boundary cells completely surround the first power domain.

10. A method of manufacturing an integrated circuit, comprising:
providing a first region of a substrate having a first conductivity type;
providing a second region of the substrate having a second conductivity type opposite to the first conductivity type;
providing a first power domain, comprising a first plurality of functional cells;
providing a second power domain, comprising a second plurality of functional cells; and
providing a plurality of boundary cells arranged to form a boundary between the first power domain and the second power domain, wherein the plurality of boundary cells physically and electrically isolate the first plurality of functional cells from the second plurality of functional cells;
providing, for each row of cells, a first power rail electrically connected to the functional cells of the first power domain;
providing, for each row of cells, a second power rail electrically connected to the functional cells of the second power domain;
and
wherein providing each boundary cell comprises:
providing a first well tap having the first conductivity type within the first region of the substrate and electrically connecting the first well tap to a ground rail;
providing a second well tap having the second conductivity type within the second region of the substrate and electrically connecting the second well tap to the first power rail; and
wherein the first and second power rails extend partially across the
boundary cell and the first power rail is physically and electrically isolated from the second power rail.

11. The method of claim 10, further comprising, providing, for each row of cells, a ground rail extending continuously across the first power domain, the second power domain and the boundary.

12. The method of claim 10 or claim 11, wherein:
providing the first well tap comprises forming a first oxide diffusion layer of the first conductivity type within the first region of the substrate and providing a first metal interconnect structure electrically connecting the first oxide diffusion layer to the ground rail; and
providing the second well tap comprises forming a second oxide diffusion layer of the second conductivity type within the second region of the substrate and providing a second metal interconnect structure electrically connecting the second oxide diffusion layer to the first power rail.

13. The method of any of claims 10 to 12, wherein the first conductivity type is a p-type conductivity and the second conductivity type is an n-type conductivity.

14. The method of any of claims 10 to 13, wherein:
the plurality of boundary cells are in direct contact with both the first power domain and the second power domain.

15. The method of any of claims 10 to 14, wherein, for each row of cells:
the second region of the substrate extends continuously across the first power domain, the boundary and the second power domain.

## Amended claims

### Amended claims in accordance with Rule 137(2) EPC.

1. An integrated circuit comprising:
a substrate, comprising a first region (203) having a first conductivity type and a second region (201) having a second conductivity type opposite to the first conductivity type;
a first power domain (100; 200), comprising a first plurality of functional cells;
a second power domain (120; 220), comprising a second plurality of functional cells; and
a plurality of boundary cells (110; 210) arranged to form a boundary between the first power domain (100; 200) and the second power domain (120; 220), wherein the plurality of boundary cells (110; 210) physically and electrically isolate the first plurality of functional cells from the second plurality of functional cells,
wherein, for each row of cells:
the functional cells of the first power domain (100; 200) are electrically connected to a first power rail (202);
the functional cells of the second power domain (120; 220) are electrically connected to a second power rail (222);
the second region (201) of the substrate extends continuously across the first power domain (100; 200), the boundary and the second power domain (120; 220); and
wherein each boundary cell (210) comprises:
a first well tap (216, 217, 218) having the first conductivity type provided within the first region (203) of the substrate, wherein the first well tap (216, 217, 218) is electrically connected to a ground rail (208);
a second well tap (212, 213, 214) having the second conductivity type provided within the second region (201) of the substrate, wherein the second well tap (212, 213, 214) is electrically connected to the first power rail (202); and
wherein the first and second power rails (202. 222) each extend partially across the boundary cell (210), the first power rail (202) being physically and electrically isolated from the second power rail (222).

2. The integrated circuit of claim 1, wherein, for each row of cells, the ground rail (208) extends continuously across the first power domain (200), the second power domain (220) and the boundary.

3. The integrated circuit of any preceding claim, wherein:
the first well tap comprises a first oxide diffusion layer (216) of the first conductivity type and a first metal interconnect structure (218) electrically connecting the first oxide diffusion layer (216) to the ground rail (208); and
the second well tap comprises a second oxide diffusion layer (212) of the second conductivity type and a second metal interconnect structure (214) electrically connecting the second oxide diffusion layer (212) to the first power rail (202).

4. The integrated circuit of any preceding claim, wherein the plurality of boundary cells (110; 210) are in direct contact with both the first power domain (100; 200) and the second power domain (120; 220).

5. The integrated circuit of any preceding claim, wherein the first conductivity type is a p-type conductivity and the second conductivity type is an n-type conductivity.

6. The integrated circuit of any preceding claim, wherein, for each row of cells:
the first region (203) of the substrate extends continuously across the first power domain (100; 200), the boundary and the second power domain (120; 220).

7. The integrated circuit of any preceding claim, wherein, for each boundary cell (210), the second power rail (222) is not connected to the boundary cell (210) by a well tap.

8. The integrated circuit of any preceding claim, wherein the boundary is of single cell width, such that a single width line of boundary cells (110; 210) are provided between the first and second power domains (100, 120; 200, 220).

9. The integrated circuit of any preceding claim, wherein the plurality of boundary cells (110; 210) completely surround the first power domain (100; 200).

10. A method of manufacturing an integrated circuit, comprising:
providing a first region (203) of a substrate having a first conductivity type;
providing a second region (201) of the substrate having a second conductivity type opposite to the first conductivity type;
providing a first power domain (100; 200), comprising a first plurality of functional cells;
providing a second power domain (120; 220), comprising a second plurality of functional cells; and
providing a plurality of boundary cells (110; 210) arranged to form a boundary between the first power domain (100; 200) and the second power domain (120; 220), wherein the plurality of boundary cells (110; 210) physically and electrically isolate the first plurality of functional cells from the second plurality of functional cells, wherein for each row of cells the second region (201) of the substrate extends continuously across the first power domain (100; 200), the boundary and the second power domain (120; 220);
providing, for each row of cells, a first power rail (202) electrically connected to the functional cells of the first power domain (200);
providing, for each row of cells, a second power rail (222) electrically connected to the functional cells of the second power domain (220);
and
wherein providing each boundary cell comprises:
providing a first well tap (216, 217, 218) having the first conductivity type within the first region (203) of the substrate and electrically connecting the first well tap to a ground rail (208);
providing a second well tap (212, 213, 214) having the second conductivity type within the second region (201) of the substrate and electrically connecting the second well tap to the first power rail (202); and
wherein the first and second power rails (202, 222) extend partially across the boundary cell (210) and the first power rail (202) is physically and electrically isolated from the second power rail (222).

11. The method of claim 10, wherein, for each row of cells, the ground rail (208)extends continuously across the first power domain (100; 200), the second power domain (120; 220) and the boundary.

12. The method of claim 10 or claim 11, wherein:
providing the first well tap comprises forming a first oxide diffusion layer (216) of the first conductivity type within the first region (203) of the substrate and providing a first metal interconnect structure (218) electrically connecting the first oxide diffusion layer (216) to the ground rail (208); and
providing the second well tap comprises forming a second oxide diffusion layer (212) of the second conductivity type within the second region (201) of the substrate and providing a second metal interconnect structure (214) electrically connecting the second oxide diffusion layer (212) to the first power rail (202).

13. The method of any of claims 10 to 12, wherein the first conductivity type is a p-type conductivity and the second conductivity type is an n-type conductivity.

14. The method of any of claims 10 to 13, wherein:
the plurality of boundary cells (110; 210) are in direct contact with both the first power domain (100; 200) and the second power domain (120; 220).
